# EUROPEAN PATENT APPLICATION

(11) **EP 1 233 417 A2**
(43) Date of publication of application: **21.08.2002**
(21) Application number: 01310107.6
(22) Date of filing: 03.12.2001
(51) Int. Cl.: G11C 7/10

(54) **Command input circuit**

(30) Priority: 16.02.2001 JP 2001039299
(71) Applicant: FUJITSU LIMITED, Kawasaki-shi, Kanagawa 211-8588 (JP)
(72) Inventor: Uchida, Toshiya, Nakahara-ku, Kawasaki-shi, Kanagawa 211 (JP)
(74) Representative: Stebbing, Timothy Charles

(57) **Abstract**

In a command input circuit: m command acquisition units (112 to 115) are provided corresponding to first to mth commands, respectively, where m is an integer greater than one; a clock signal supplying unit (100) supplies n clock signals respectively having different phases to the m command acquisition units (112 to 115), where n is an integer greater than one; and a command input unit (110, 130) receives said first to mth commands, and supplies the first to mth commands to the m command acquisition units (112 to 115). Each of the m command acquisition units acquires one of the first to mth commands corresponding to the command acquisition unit in response to one of m edges of the n clock signals corresponding to the one of the first to mth commands. The processing unit performs processing in accordance with the first to mth commands.

## Description

The present invention relates to a command input circuit which separately receives and acquires (or latches) a series of commands in synchronization with a clock signal. The present invention also relates to a data handling device including the above command input circuit. The data handling device handles (e.g., processes or stores) data in accordance with the series of commands. Typically, such a command input circuit or data handling device can be realized in a semiconductor device. For example, the present invention can be used in a semiconductor memory device.

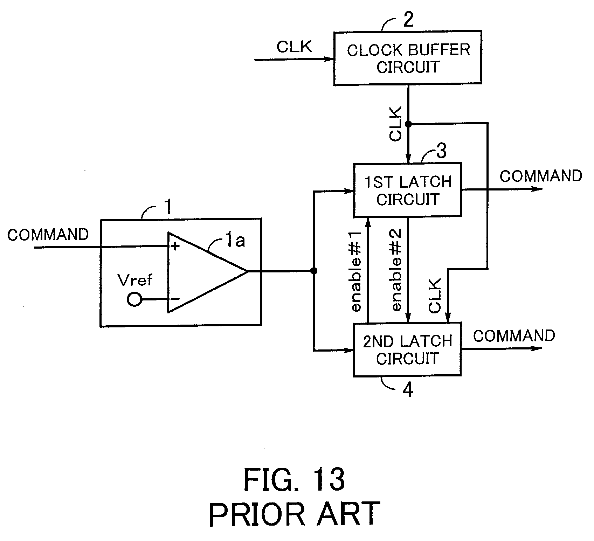

Fig. 13 is a diagram illustrating an example of a known command input circuit.

In the command input circuit of Fig. 13, the input circuit 1 includes an input amplifier 1a, which receives signals conveying commands, compares the signals with a reference voltage Vref, performs signal shaping, and outputs the shaped signals. The clock buffer circuit 2 receives and shapes a clock signal, adjusts the level of the clock signal, and outputs the shaped and level-adjusted clock signal. The first latch circuit 3 latches and outputs a first command when the first command is supplied from the input circuit 1 to the first latch circuit 3, and the second latch circuit 4 latches and outputs a second command when the second command is supplied from the input circuit 1 to the second latch circuit 4.

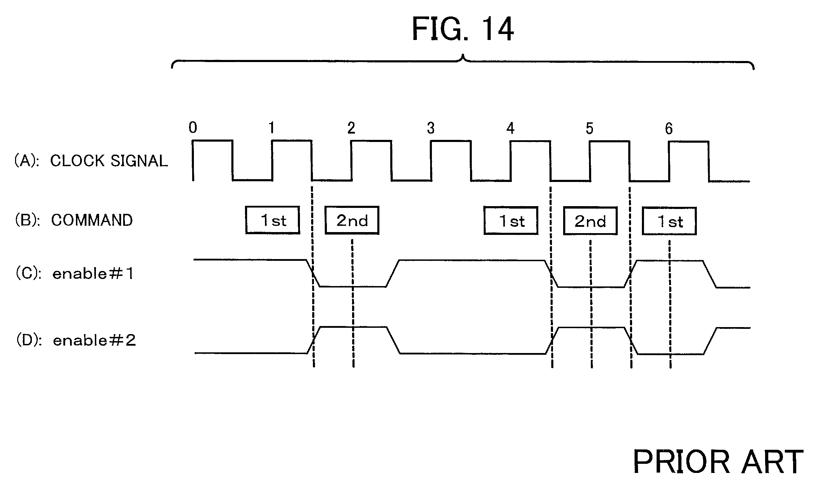

Fig. 14 is a timing diagram illustrating typical operations of the command input circuit of Fig. 13.

When the command input circuit of Fig. 13 is powered up, the first latch circuit 3 is reset at the timing of the 0-th rising edge of the clock signal as indicated with (A) in Fig. 14, so that the first latch circuit 3 is put into the state in which the first latch circuit 3 can receive a new command.

Next, when a signal conveying a first command is input into the input circuit 1 at the timing of the first rising edge of the clock signal as indicated with (B) in Fig. 14, the input circuit 1 shapes the signal, and supplies the shaped signal to the first latch circuit 3 and the second latch circuit 4. At this time, the first latch circuit 3 determines whether or not the supplied command is a first command, and whether or not the supplied command is normal (e.g. valid or executable). When a normal first command is supplied to the first latch circuit 3, the first latch circuit 3 brings an enable #2 signal to an active state ("H" level) as indicated with (D) in Fig. 14, where the enable #2 signal is supplied from the first latch circuit 3 to the second latch circuit 4.

When the second latch circuit 4 detects the active enable #2 signal, the second latch circuit 4 latches a second command which is supplied to the second latch circuit 4, at the timing of the second rising edge of the clock signal. Then, the second latch circuit 4 determines whether or not the supplied command is a second command, and whether or not the supplied command is normal. When the second latch circuit 4 determines that a normal second command is supplied to the second latch circuit 4, the second latch circuit 4 brings an enable #1 signal to an active state ("H" level) as indicated with (C) in Fig. 14, where the enable #1 signal is supplied from the second latch circuit 4 to the first latch circuit 3.

Thereafter, when a signal conveying a first command is input into the input circuit 1 again at the timing of the fourth rising edge of the clock signal, the first latch circuit 3 receives and processes the signal conveying the first command in the same manner as that at the timing of the first rising edge of the clock signal.

By repeating the above operations, the first and second commands are separated and supplied to the following stages.

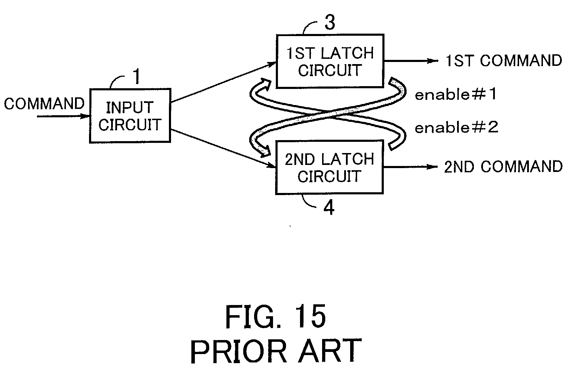

Fig. 15 is a diagram schematically illustrating the operations of the command input circuit of Fig. 13. As illustrated in Fig. 15, each command input through the input circuit 1 is supplied to both of the first latch circuit 3 and the second latch circuit 4. When the supplied command is a first command, the first latch circuit 3 latches and outputs the command, and brings the enable #2 signal to the active state ("H" level). On the other hand, when the enable #2 signal supplied from the first latch circuit 3 to the second latch circuit 4 is active, the second latch circuit 4 latches and outputs a command which is input next, and brings the enable #1 signal to the active state ("H" level).

However, in the above command input circuit, each of the first and second latch circuits is required to determine whether or not a command supplied to the latch circuit is appropriate and normal, and generate the enable #1 or enable #2 signal, after the command is input into the latch circuit. That is, each of the first and second latch circuits is required to make a determination every time a command is input. Therefore, when the frequency of the clock signal is increased, it is not possible to allow each latch circuit a sufficient time for the determination, and expect the command input circuit to operate normally.

Embodiments of the present invention provide a command input circuit which can separately receive a series of commands in synchronization with a clock signal even when the frequency of the clock signal is high.

Further embodiments of the present invention provide a data handling device including a command input circuit which can separately receive a series of commands in synchronization with a clock signal even when the frequency of the clock signal is high.

According to the first aspect of the present invention, there is provided a command input circuit comprising a clock signal supplying unit, a command input unit, and first and second command acquisition units. The clock signal supplying unit supplies a clock signal to the first and second command acquisition units. The command input unit receives first and second commands, and supplies the first and second commands to the first and second command acquisition units. The first command acquisition unit acquires the first command in response to a first edge of the clock signal, where the first edge is one of a rising edge and a falling edge of the clock signal. The second command acquisition unit acquires the second command in response to a second edge of the clock signal, where the second edge is an edge of the clock signal which is different from the first edge.

According to the second aspect of the present invention, there is provided a data handling device comprising: a clock signal supplying unit; a command input unit; first and second command acquisition units; and a processing unit. The clock signal supplying unit supplies a clock signal to first and second command acquisition units. The command input unit receives the first and second commands, and supplies the first and second commands to the first and second command acquisition units. The first command acquisition unit acquires the first command in response to a first edge of the clock signal, where the first edge is one of a rising edge and a falling edge of the clock signal. The second command acquisition unit acquires the second command in response to a second edge of the clock signal, where the second edge is an edge of the clock signal which is different from the first edge. The processing unit performs processing in accordance with the first and second commands.

The data handling device according to the second aspect of the present invention may have one or any possible combination of the following additional features (i) to (v) .
(i) The processing unit may start the processing when the processing unit receives the first command.
(ii) When the data handling device according to the second aspect of the present invention has the above feature (i), the processing unit may stop the processing when the processing unit determines that the second command is not normal.
(iii) When the data handling device according to the second aspect of the present invention has the above feature (i), the processing unit may go into a predetermined operation mode corresponding to the second command when the processing unit receives the second command.
(iv) The data handling device according to the second aspect of the present invention may further comprise: an address input unit which receives a first address and a second address, and supplies the first address and the second address to a first address acquisition unit and a second address acquisition unit; the first address acquisition unit which acquires the first address in response to the first edge of the clock signal; and the second address acquisition unit which acquires the second address in response to the second edge of the clock signal.
(v) The data handling device according to the second aspect of the present invention may further comprise a data input-and-output unit which receives and outputs data in response to the rising edge and the falling edge of the clock signal.
   According to the third aspect of the present invention, there is provided a command input circuit comprising m command acquisition units, a clock signal supplying unit, and a command input unit, where m is an integer greater than one. The m command acquisition units are provided corresponding to first to mth commands, respectively. The clock signal supplying unit supplies n clock signals respectively having different phases to the m command acquisition units, where n is an integer greater than one. The command input unit receives the first to mth commands, and supplies the first to mth commands to the m command acquisition units. In the data handling device, each of the m command acquisition units acquires one of the first to mth commands corresponding to the command acquisition unit in response to one of m edges of the n clock signals corresponding to the one of the first to mth commands.
   According to the fourth aspect of the present invention, there is provided a data handling device comprising m command acquisition units, a clock signal supplying unit, a command input unit, and a processing unit, where m is an integer greater than one. The m command acquisition units are provided corresponding to first to mth commands, respectively. The clock signal supplying unit supplies n clock signals respectively having different phases to the m command acquisition units, where n is an integer greater than one. The command input unit receives the first to mth commands, and supplies the first to mth commands to the m command acquisition units. In the data handling device, each of the m command acquisition units acquires one of the first to mth commands corresponding to the command acquisition unit in response to one of m edges of the n clock signals corresponding to the one of the first to mth commands. The processing unit performs processing in accordance with the first to mth commands.
   The data handling device according to the fourth aspect of the present invention may have one or any possible combination of the following additional features (vi) to (xi).
(vi) The processing unit may start the processing when the processing unit receives the first command.
(vii) When the data handling device according to the fourth aspect of the present invention has the above feature (vi), the processing unit may stop the processing when the processing unit determines that one of the second to mth commands is not normal.
(viii) When the data handling device according to the fourth aspect of the present invention has the above feature (vi), the processing unit may go into a predetermined operation mode corresponding to one of the second to mth commands when the processing unit receives the one of the second to mth commands.
(ix) The first command may indicate one of no operation, a read operation, and a write operation. In the data handling device, the processing unit starts the processing when the processing unit receives the first command. In addition, when the processing unit receives at least a portion of the second to mth commands, the processing unit may determine whether to continue one of the read operation and the write operation or to go into a predetermined operation mode, according to a combination of the first command and the at least a portion of the second to mth commands.
(x) The data handling device according to the fourth aspect of the present invention may further comprise first to pth address acquisition units and an address input unit, where p is an integer greater than one. The first to pth address acquisition units are provided corresponding to first to pth addresses, respectively. The address input unit receives the first to pth addresses, and supplies the first to pth addresses to the first to pth address acquisition units. In the data handling device, each of the first to pth address acquisition units acquires one of the first to pth addresses corresponding to the address acquisition unit in response to one of p edges of the n clock signals corresponding to the one of the first to pth addresses.
(xi) The data handling device according to the fourth aspect of the present invention may further comprise a data input-and-output unit which receives or outputs data in response to j edges of the n clock signals, where j is an integer greater than one.

In the command input circuits according to the first and third aspects of the present invention and the data handling devices according to the second and fourth aspects of the present invention, it is possible to secure a time margin for increasing the frequency of the clock signal or clock signals. In addition, the power consumption can be reduced.

Reference will now be made by way of example only to the accompanying drawings, in which:
Fig. 1 is a diagram illustrating a basic construction of a data handling device according to the present invention;
Fig. 2 is a diagram illustrating a construction of a data handling device as a first embodiment of the present invention;
Fig. 3 is a timing diagram illustrating operations of the data handling device of Fig. 2;
Fig. 4 is a diagram schematically illustrating the operations of the data handling device of Fig. 2;
Fig. 5 is a timing diagram illustrating detailed operations of the data handling device of Fig. 2;
Fig. 6A is a timing diagram illustrating timings of a clock signal and latched commands in the data handling device of Fig. 2;
Fig. 6B is a timing diagram illustrating timings of a clock signal and latched commands in a known data handling device;
Fig. 7 is a diagram illustrating a construction of a data handling device as a second embodiment of the present invention;
Fig. 8 is a timing diagram illustrating operations of the data handling device of Fig. 7;
Fig. 9 is a diagram illustrating a construction of a data handling device as a third embodiment of the present invention;
Fig. 10 is a diagram illustrating an example of a construction of a clock buffer circuit in Fig. 9;
Fig. 11 is a timing diagram illustrating operations of the clock buffer circuit of Fig. 10;
Fig. 12 is a diagram illustrating a construction of a data handling device as a fourth embodiment of the present invention;
Fig. 13 is a diagram illustrating an example of a known command input circuit;
Fig. 14 is a timing diagram illustrating typical operations of the command input circuit of Fig. 13; and
Fig. 15 is a diagram schematically illustrating the operations of the command input circuit of Fig. 13.

Embodiments of the present invention are explained in detail below with reference to the drawings.

### (1) Basic Construction

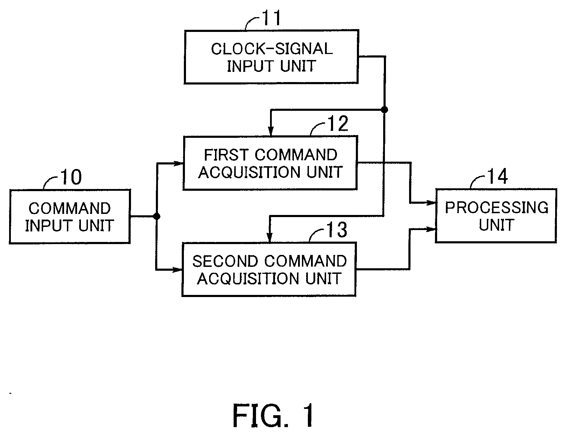

Fig. 1 is a diagram illustrating a basic construction of a data handling device according to the present invention. The data handling device of Fig. 1 comprises a command input unit 10, a clock-signal input

unit 11, a first command acquisition unit 12, a second command acquisition unit 13, and a processing unit 14.

The command input unit 10 receives a command which is supplied from outside, and supplies the received command to the first command acquisition unit 12 and the second command acquisition unit 13. The clock-signal input unit 11 receives a clock signal which is also supplied from outside, and supplies the clock signal to the first command acquisition unit 12 and the second command acquisition unit 13.

The first command acquisition unit 12 acquires (or latches) a first command which is supplied from the command input unit 10, in synchronization with a first edge of the clock signal, where the first edge is a rising edge or a falling edge of the clock signal. The second command acquisition unit 13 acquires (or latches) a second command which is supplied from the command input unit 10, in synchronization with a second edge of the clock signal, where the second edge is an edge of the clock signal which is different from the first edge.

The operations of the data handling device of Fig. 1 are explained below. In the following explanations, it is assumed that the first command acquisition unit 12 acquires a first command in synchronization with a rising edge of the clock signal, and the second command acquisition unit 13 acquires a second command in synchronization with a falling edge of the clock signal.

A first command is input into the command input unit 10 in synchronization with a rising edge of the clock signal, and a second command is input into the command input unit 10 in synchronization with a falling edge of the clock signal.

The first command acquisition unit 12 acquires a command supplied from the command input unit 10 in

synchronization with a rising edge of the clock signal which is supplied through the clock-signal input unit 11. Since the first command is input into the command input unit 10 in synchronization with the rising edge of the clock signal, the first command acquisition unit 12 can reliably acquire every first command.

On the other hand, the second command acquisition unit 13 acquires a command supplied from the command input unit 10 in synchronization with a falling edge of the clock signal which is supplied through the clock-signal input unit 11. Since the second command is input into the command input unit 10 in synchronization with the falling edge of the clock signal, the second command acquisition unit 13 can reliably acquire every second command.

The first and second commands acquired by and output from the first command acquisition unit 12 and the second command acquisition unit 13 are supplied to the processing unit 14, which determines whether or not the first and second commands are normal. When the processing unit 14 determines that the first and second commands are normal, the processing unit 14 executes the first and second commands.

In the known command input circuit of Fig. 13, each of the first latch circuit 3 and the second latch circuit 4 is required to perform the operations of: latching a command; determining whether the command is a first command or a second command; determining whether or not the command is normal; and generating an enable signal. However, as described above, in the construction of Fig. 1, the rising edge and falling edge of the clock signal are associated with the first and second commands, respectively. Therefore, each of the first command acquisition unit 12 and the second command acquisition unit 13 is not required to perform the operations of determining whether the received

command is a first command or a second command, and generating an enable signal. Thus, it is possible to increase the processing speed in the first command acquisition unit 12 and the second command acquisition unit 13.

In addition, in the construction of Fig. 1, each of the first command acquisition unit 12 and the second command acquisition unit 13 perform only the operation of acquiring a command, and the operation of determining whether or not the received command is normal is performed by the processing unit 14. That is, the processing load is shared between the processing unit 14 and each of the first and second command acquisition units 12 and 13. Therefore, it is possible to increase the processing speed in the entire data handling device.

### (2) First Embodiment

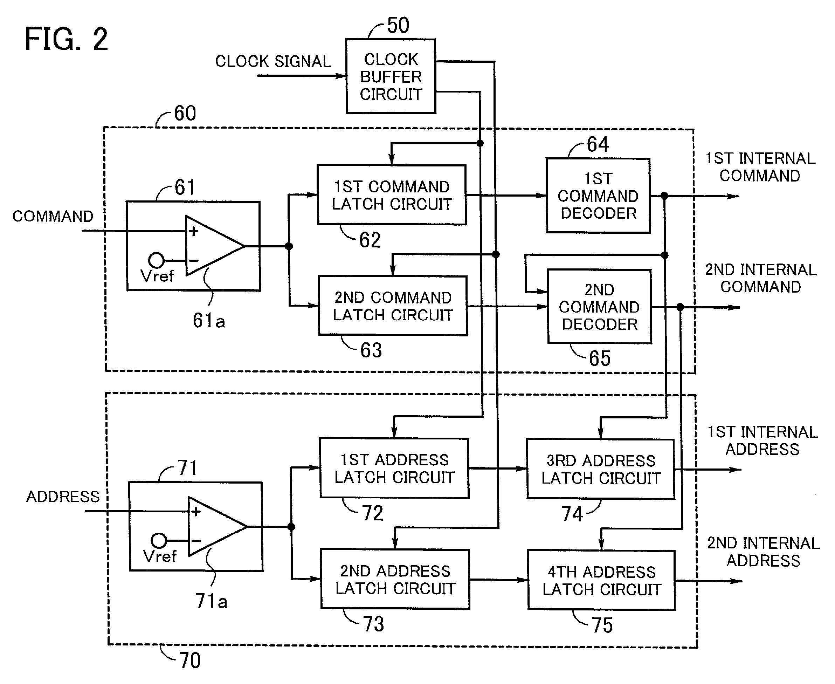

Fig. 2 is a diagram illustrating a construction of a data handling device as a first embodiment of the present invention. The data handling device of Fig. 2 comprises a clock buffer circuit 50, a command input block 60, and an address input block 70.

Fig. 2 is a diagram illustrating a construction of a data handling device as a first embodiment of the present invention. The data handling device of Fig. 2 comprises a clock buffer circuit 50, a command input block 60, and an address input block 70.

The clock buffer circuit 50 receives an external clock signal, and outputs two clock signals #1 and #2, as explained later.

The clock buffer circuit 50 receives an external clock signal, and outputs two clock signals #1 and #2, as explained later.

The command input block 60 comprises an input circuit 61, a first command latch circuit 62, a second command latch circuit 63, a first command decoder 64, and a second command decoder 65. The command input block 60 separately receives first and second commands, and supplies the first and second commands as first and second internal commands to a data handling circuit (not shown) in the following stage.

The input circuit 61 includes an input amplifier 61a, receives a command signal conveying a command,

compares the command signal with a reference voltage Vref, performs signal shaping, and outputs the shaped command signal. The first command latch circuit 62 latches and outputs a first command in synchronization with the clock signal #1, and the second command latch circuit 63 latches and outputs a second command in synchronization with the clock signal #2.

The first command decoder 64 decodes the first command supplied from the first command latch circuit 62, generates a first internal command, and supplies the first internal command to the data handling circuit in the following stage. In addition, the first internal command is also supplied to the second command decoder 65 and a third address latch circuit 74 in the address input block 70. The second command decoder 65 decodes the second command supplied from the second command latch circuit 63 and the first internal command supplied from the first command decoder 64, generates a second internal command, and supplies the second internal command to the data handling circuit in the following stage. In addition, the second internal command is also supplied to a fourth address latch circuit 75 in the address input block 70.

The first command decoder 64 decodes the first command supplied from the first command latch circuit 62, generates a first internal command, and supplies the first internal command to the data handling circuit in the following stage. In addition, the first internal command is also supplied to the second command decoder 65 and a third address latch circuit 74 in the address input block 70. The second command decoder 65 decodes the second command supplied from the second command latch circuit 63 and the first internal command supplied from the first command decoder 64, generates a second internal command, and supplies the second internal command to the data handling circuit in the following stage. In addition, the second internal command is also supplied to a fourth address latch circuit 75 in the address input block 70.

The address input block 70 comprises an input circuit 71, a first address latch circuit 72, a second address latch circuit 73, the third address latch circuit 74, and the fourth address latch circuit 75. The address input block 70 latches first and second addresses in accordance with the first and second internal commands supplied from the command input block 60, and supplies the first and second addresses as first and second internal addresses to the data handling circuit in the following stage.

The input circuit 71 includes an input amplifier 71a, which receives an address signal conveying an address, compares the address signal with a reference

The input circuit 71 includes an input amplifier 71a, which receives an address signal conveying an address, compares the address signal with a reference voltage Vref, performs signal shaping, and outputs the shaped address signal. The first address latch circuit 72 latches and outputs a first address in synchronization with the clock signal #1, and the second address latch circuit 73 latches and outputs a second address in synchronization with the clock signal #2.

The third address latch circuit 74 latches the first address supplied from the first address latch circuit 72, in accordance with the first internal command supplied from the first command decoder 64, generates a first internal address, and supplies the first internal address to the data handling circuit in the following stage. The fourth address latch circuit 75 latches the second address supplied from the second address latch circuit 73, in accordance with the second internal command supplied from the second command decoder 65, generates a second internal address, and supplies the second internal address to the data handling circuit in the following stage.

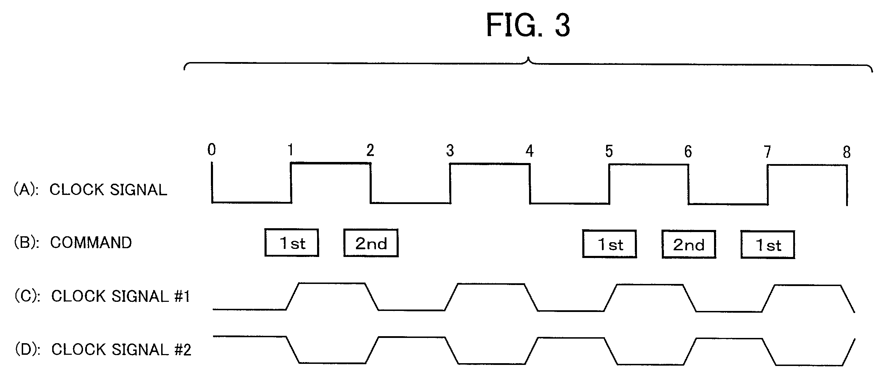

The operations of the data handling device of Fig. 2 are explained below with reference to Figs. 3, 4, and 5.

The operations of the data handling device of Fig. 2 are explained below with reference to Figs. 3, 4, and 5.

Fig. 3 is a timing diagram illustrating operations of the data handling device of Fig. 2.

As illustrated in Fig. 3, the clock buffer circuit 50 receives an external clock signal (A), and generates the clock signals #1 and #2, where the clock signal #1 is in phase with the external clock signal, and the clock signal #2 is in anti-phase with the external clock signal, as indicated with (C) and (D) in Fig. 3.

In addition, first commands are latched in synchronization with the clock signal #1, and second commands are latched in synchronization with the clock signal #2. Therefore, it is not necessary to discriminate between the first and second commands,

i.e., the operation of determining whether a received command is a first command or a second command can be dispensed with.

Further, even when a received first command is not normal, it is not necessary to determine whether or not a subsequent second command is appropriate before the second command is input. Therefore, it is possible to secure a sufficient time margin for latching the second command.

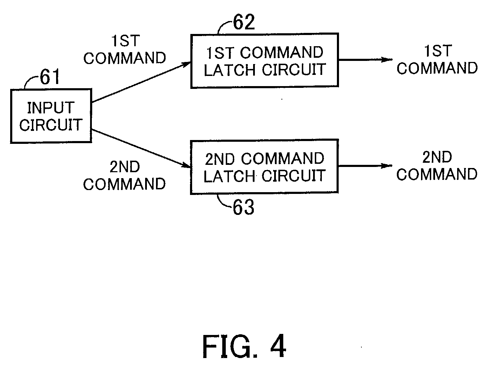

The operations of the data handling device of Fig. 2 are schematically illustrated in Fig. 4. When the operations illustrated in Fig. 4 are compared with those illustrated in Fig. 15, it is clear that each of the first command latch circuit 62 and the second command latch circuit 63 is not required to determine whether a received command is a first command or a second command, and generate an enable signal. Thus, the processing speed can be increased.

The operations of the data handling device of Fig. 2 are schematically illustrated in Fig. 4. When the operations illustrated in Fig. 4 are compared with those illustrated in Fig. 15, it is clear that each of the first command latch circuit 62 and the second command latch circuit 63 is not required to determine whether a received command is a first command or a second command, and generate an enable signal. Thus, the processing speed can be increased.

The operations of the data handling device of Fig. 2 are schematically illustrated in Fig. 4. When the operations illustrated in Fig. 4 are compared with those illustrated in Fig. 15, it is clear that each of the first command latch circuit 62 and the second command latch circuit 63 is not required to determine whether a received command is a first command or a second command, and generate an enable signal. Thus, the processing speed can be increased.

The operations of the data handling device of Fig. 2 are schematically illustrated in Fig. 4. When the operations illustrated in Fig. 4 are compared with those illustrated in Fig. 15, it is clear that each of the first command latch circuit 62 and the second command latch circuit 63 is not required to determine whether a received command is a first command or a second command, and generate an enable signal. Thus, the processing speed can be increased.

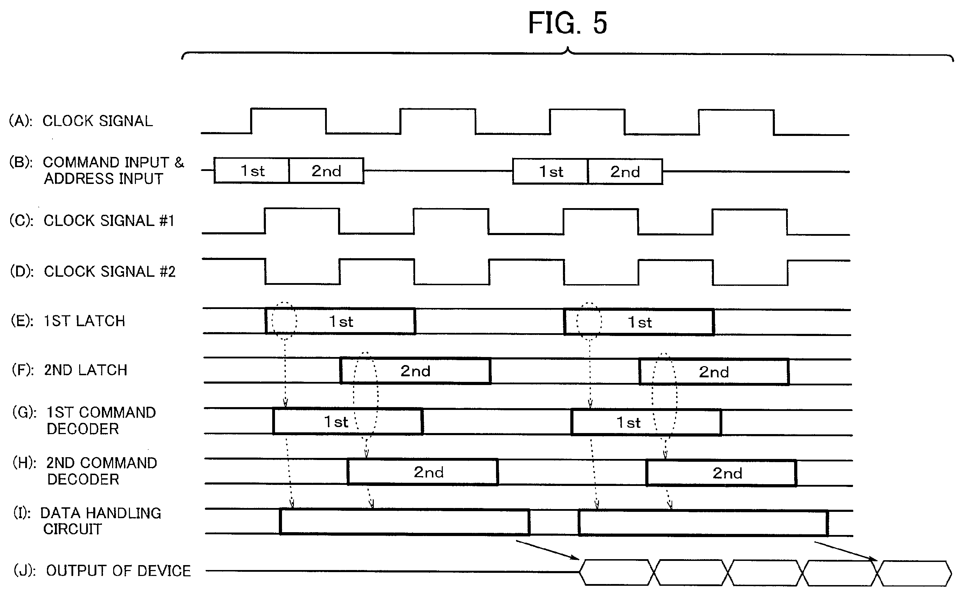

Fig. 5 is a timing diagram illustrating detailed operations of the data handling device of Fig. 2.

When the external clock signal (as indicated with (A) in Fig. 5) is supplied to the data handling device of Fig. 2, the clock buffer circuit 50 generates the clock signal #1 (as indicated with (C) in Fig. 5) and the clock signal #2 (as indicated with (D) in Fig. 5), and supplies the clock signals #1 and #2 to the respective portions of the data handling device of Fig. 2.

A first command is input into the input circuit 61 in synchronization with a rising edge of the external clock signal, and a second command is input into the input circuit 61 in synchronization with a falling edge of the external clock signal, as indicated with (B) in Fig. 5. The input circuit 61 shapes command signals conveying the first and second commands, and supplies the shaped command signals to the first command latch

circuit 62 and the second command latch circuit 63.

The first command latch circuit 62 latches the first command supplied from the input circuit 61, in synchronization with a rising edge of the clock signal #1, as indicated with (E) in Fig. 5. The second command latch circuit 63 latches the second command supplied from the input circuit 61, in synchronization with a rising edge of the clock signal #2, as indicated with The first command latch circuit 62 latches the first command supplied from the input circuit 61, in synchronization with a rising edge of the clock signal #1, as indicated with (E) in Fig. 5. The second command latch circuit 63 latches the second command supplied from the input circuit 61, in synchronization with a rising edge of the clock signal #2, as indicated with (F) in Fig. 5.

The first command decoder 64 decodes the first command supplied from the first command latch circuit 62, generates a first internal command as indicated with (G) in Fig. 5, and outputs the first internal command to the data handling circuit in the following stage. At this time, the first internal command is also supplied to the second command decoder 65 and the third address latch circuit 74.

The second command decoder 65 decodes the first internal command supplied from the first command decoder 64 and the second command supplied from the second command latch circuit 63, and determines whether or not the combination of the first internal command and the second command is normal (e.g. an acceptable or possible combination of commands). If the combination of the first internal command and the second command is normal, the second command decoder 65 generates a second internal command, as indicated with (H) in Fig. 5, and supplies the second internal command to the data handling circuit in the following stage. In addition, the second internal command is also supplied to the fourth address latch circuit 75 in the address input block 70.

On the other hand, in the address input block 70, a first address is latched by the first address latch circuit 72 in synchronization with a rising edge of the clock signal #1, and a second address is latched by the second address latch circuit 73 in synchronization with a rising edge of the clock signal #2.

Then, the third address latch circuit 74 latches the first address in accordance with the first internal command supplied from the first command decoder 64, and outputs the first address as a first internal address to the data handling circuit in the following stage. In addition, the fourth address latch circuit 75 latches the second address in accordance with the second internal command supplied from the second command decoder 65, and outputs the second address as a second internal address to the data handling circuit in the following stage.

Although not shown in Fig. 2, the above data handling circuit performs predetermined processing in accordance with the first and second internal commands supplied from the command input block 60. When the first internal command is supplied from the first command decoder 64 to the data handling circuit, the data handling circuit starts its operation, as indicated with (I) in Fig. 5. Subsequently, when the second internal command is output from the second command decoder 65 to the data handling circuit, the data handling circuit appropriately modifies the course of the operation in accordance with the second internal command, and continues the operation. When the data handling circuit determines that the first command or the second command is not normal, the data handling circuit stops the operation. When the data handling circuit performs the predetermined processing, and then desired data is obtained, the obtained data is output from the data handling circuit, as indicated with (J) in Fig. 5. In the case where the data handling device of Fig. 2 is formed in a semiconductor device, the above data is output from the semiconductor device.

As explained above, in the first embodiment of the present invention, the rising edge and falling edge of the external clock signal are associated with the first and second commands, respectively, and the first and second commands are input at the timings of the rising edge and falling edge of the external clock signal, respectively. Therefore, the command latch circuits are not required to make the aforementioned determinations which are required in the known command input circuit. Thus, it is possible to increase the processing speed in the command input block 60.

In addition, the execution of a command is started when the first command is acquired. Therefore, when a sufficient margin is provided for processing, the data handling device can be stable even in a high speed operation.

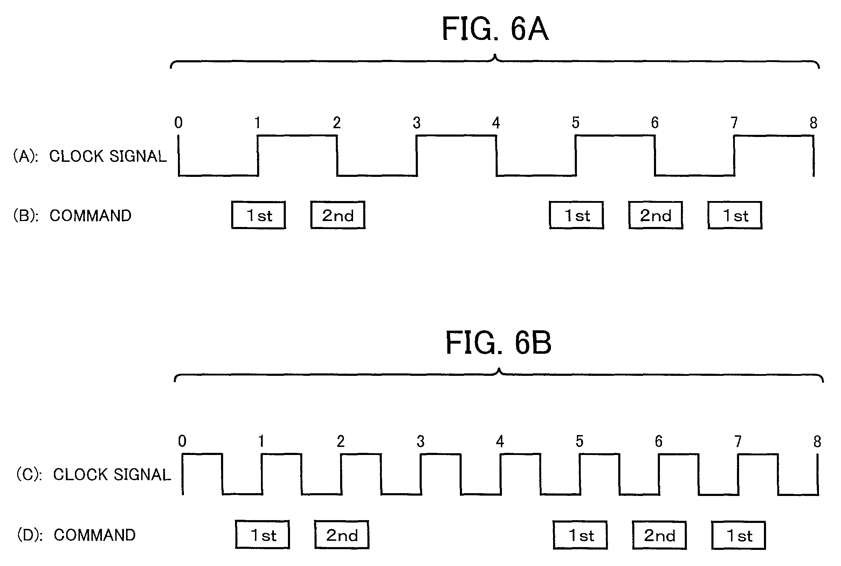

Further, since the commands are latched in synchronization with rising edges and falling edges of the external clock signal, it is possible to reduce power consumption, as explained below with reference to Figs. 6A and 6B.

Fig. 6A is a timing diagram illustrating timings of the clock signal and latched commands in the data handling device of Fig. 2, and Fig. 6B is a timing diagram illustrating timings of the clock signal and latched commands in a known data handling device.

As illustrated in Figs. 6A and 6B, the command input block 60 in the data handling device of Fig. 2 can achieve the same command latch rate as the known data handling device, with a clock signal having a frequency which is one-half the frequency of the clock signal in the known command input circuit. That is, the data handling device of Fig. 2 can achieve the same performance as the known data handling device in the command latch operation with a clock signal having a half frequency. Thus, the power consumption can be reduced.

Although the clock signal is externally supplied to the data handling device of Fig. 2, alternatively, the clock signal may be generated inside the data handling device.

When the DDR (Double Data Rate) technique is used for data input and output operations in the entire data handling device of Fig. 2 in addition to the above improvement in the command latch operation, it is possible to further increase the processing speed of the entire data handling device of Fig. 2.

Further, in the case where the data handling device of Fig. 2 is used in a semiconductor memory device, and a first command includes logic information based on which at least a basic operation such as no operation, a read operation, or a write operation can be recognized, the data handling device (circuit) can start a basic operation such as a read operation or a write operation when the first command is read by the data handling device. When a second command is subsequently input, the data handling device determines whether to continue the read or write operation or to go into another operation mode, based on the combination of the first and second commands. The operation mode into which the data handling device can go is an additional operation such as a refresh operation. Since the basic operation such as a read or write operation can be started in response to a first command, no access loss occurs even when an entire command is split into first and second commands, and the first and second commands are successively input into the data handling device. In addition, when the entire command is split into first and second commands, and the first and second commands are successively input into the data handling device through the same input terminals, the number of the input terminals can be reduced.

### (3) Second Embodiment

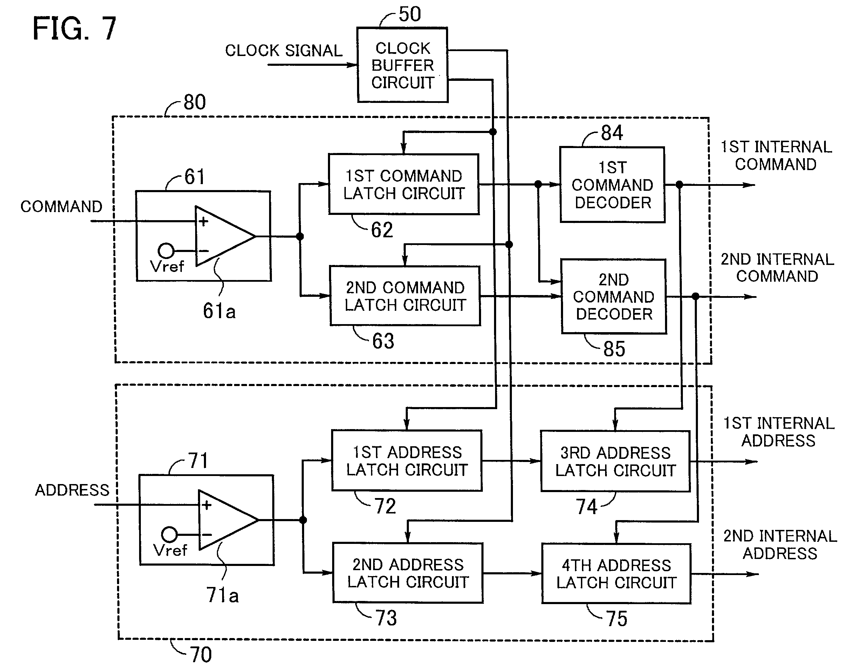

Fig. 7 is a diagram illustrating a construction of a data handling device as a second embodiment of the present invention. In Fig. 7, the same elements as Fig. 2 have the same reference numbers as Fig. 2, and the explanations on the same elements as Fig. 2 are not repeated.

The construction of Fig. 7 is different from the construction of Fig. 2 in a portion of the command input block 80. That is, in the command input block 80 in the construction of Fig. 7, the first command output from the first command latch circuit 62 is directly supplied to a second command decoder 85, while the first internal command output from the first command decoder 64 is supplied to the second command decoder 65 in the command input block 60 in the construction of Fig. 2.

Thus, the first command decoder 84 decodes the first command supplied from the first command latch circuit 62, generates a first internal command, and supplies the first internal command to the data handling circuit in the following stage and the third address latch circuit 74 in the address input block 70. The second command decoder 85 decodes the second command supplied from the second command latch circuit 63 and the first command supplied from the first command latch circuit 62, generates a second internal command, and supplies the second internal command to the data handling circuit in the following stage and the fourth address latch circuit 75 in the address input block 70.

The other portions of the constructions of the Figs. 2 and 7 are identical.

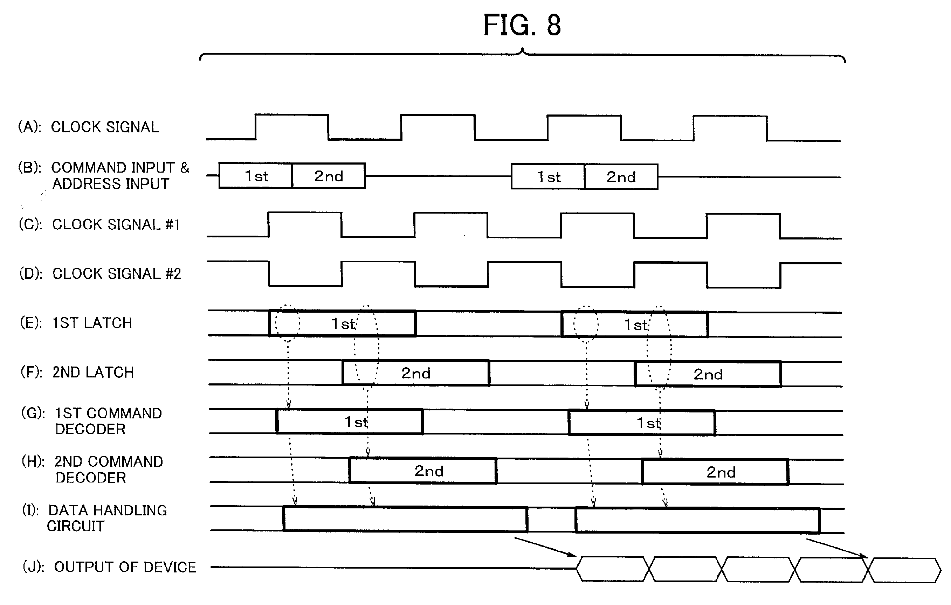

The operations of the data handling device of Fig. 7 are explained below with reference to Fig. 8, which is a timing diagram illustrating operations of the data

handling device of Fig. 7.

When the external clock signal (as indicated with.

(A) in Fig. 8) is supplied to the data handling device of Fig. 7, the clock buffer circuit 50 generates the clock signal #1 (as indicated with (C) in Fig. 8) and the clock signal #2 (as indicated with (D) in Fig. 8), and supplies the clock signals #1 and #2 to the respective portions of the data handling device of Fig. 7.

A first command is input into the input circuit 61 in synchronization with a rising edge of the external clock signal, and a second command is input into the input circuit 61 in synchronization with a falling edge of the external clock signal, as indicated with (B) in Fig. 8. The input circuit 61 shapes command signals conveying the first and second commands, and supplies the shaped command signals to the first command latch circuit 62 and the second command latch circuit 63.

The first command latch circuit 62 latches the first command supplied from the input circuit 61, in synchronization with a rising edge of the clock signal #1, as indicated with (E) in Fig. 8.

The first command latch circuit 62 latches the first command supplied from the input circuit 61, in synchronization with a rising edge of the clock signal #1, as indicated with (E) in Fig. 8.

The first command latch circuit 62 latches the first command supplied from the input circuit 61, in synchronization with a rising edge of the clock signal #1, as indicated with (E) in Fig. 8.

The second command latch circuit 63 latches the second command supplied from the input circuit 61, in synchronization with a rising edge of the clock signal #2, as indicated with (F) in Fig. 8.

The first command decoder 84 decodes the first command supplied from the first command latch circuit 62, generates a first internal command as indicated with (G) in Fig. 8, and outputs the first internal command to the data handling circuit in the following stage and the third address latch circuit 74.

The second command decoder 85 decodes the first command supplied from the first command latch circuit 62 and the second command supplied from the second command latch circuit 63, and determines whether or not

the combination of the first command and the second command is normal. When the second command decoder 85 determines that the combination of the first command and the second command is normal, the second command decoder 85 generates a second internal command, as indicated with (H) in Fig. 8, and supplies the second internal command to the data handling circuit in the following stage and the fourth address latch circuit 75 in the address input block 70.

On the other hand, in the address input block 70, a first address is latched by the first address latch circuit 72 in synchronization with a rising edge of the clock signal #1, and a second address is latched by the second address latch circuit 73 in synchronization with a rising edge of the clock signal #2.

Then, the third address latch circuit 74 latches the first address in accordance with the first internal command supplied from the first command decoder 84, and outputs the first address as a first internal address to the data handling circuit in the following stage. In addition, the fourth address latch circuit 75 latches the second address in accordance with the second internal command supplied from the second command decoder 85, and outputs the second address as a second internal address to the data handling circuit in the following stage.

Although not shown in Fig. 7, the above data handling circuit performs predetermined processing in accordance with the first and second internal commands supplied from the command input block 80. When the first internal command is supplied from the first command decoder 84 to the data handling circuit, the data handling circuit starts its operation, as indicated with (I) in Fig. 8. Subsequently, when the second internal command is supplied from the second command decoder 85 to the data handling circuit, the

data handling circuit appropriately modifies the course of the operation in accordance with the second internal command, and continues the operation. When the data handling circuit determines that the first command or the second command is not normal, the data handling circuit stops the operation. When the circuit in the following stage performs the predetermined processing, and then desired data is obtained, the obtained data is output from the data handling circuit, as indicated with (J) in Fig. 8. In the case where the data handling device of Fig. 7 is formed in a semiconductor device, the above data is output from the semiconductor device.

Thus, similar to the construction of Fig. 2, the high-speed command latch operation can be realized.

### (4) Third Embodiment

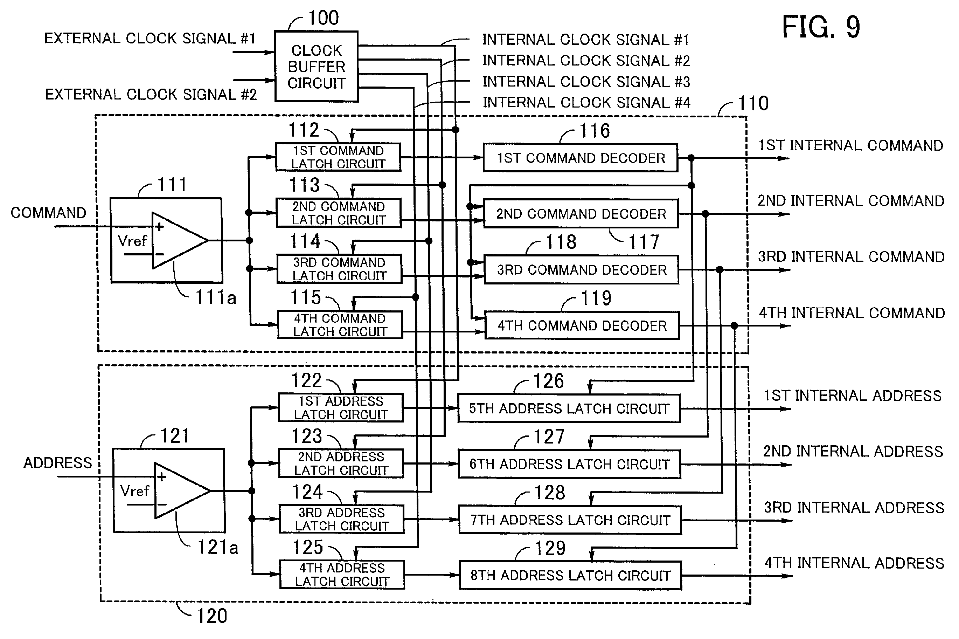

Fig. 9 is a diagram illustrating a construction of a data handling device as a third embodiment of the present invention. The data handling device of Fig. 9 comprises a clock buffer circuit 100, a command input block 110, and an address input block 120.

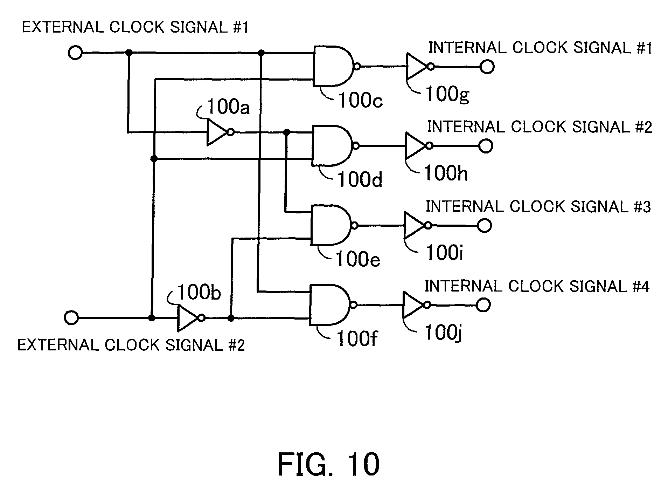

The clock buffer circuit 100 receives external clock signals #1 and #2, and outputs internal clock signals #1 to #4. Fig. 10 is a diagram illustrating an example of a construction of the clock buffer circuit 100 in Fig. 9. The clock buffer circuit 100 of Fig. 10 comprises inverters 100a and 100b, NAND circuit elements 100c to 100f, and inverters 100g to 100j.

The inverter 100a receives and inverts the external clock signal #1, and supplies the inverted external clock signal #1 to the NAND circuit elements 100d and 100e. The inverter 100b receives and inverts the external clock signal #2, and supplies the inverted external clock signal #2 to the NAND circuit elements 100e and 100f.

The NAND circuit element 100c obtains and outputs an inversion of a logical product of the external clock signals #1 and #2. The NAND circuit element 100d obtains and outputs an inversion of a logical product of the external clock signal #2 and the output of the inverter 100a. The NAND circuit element 100e obtains and outputs an inversion of a logical product of the outputs of the inverters 100a and 100b. The NAND circuit element 100f obtains and outputs an inversion of a logical product of the external clock signal #1 and the output of the inverter 100b. The inverters 100g to 100j outputs inversions of the outputs of the NAND circuit elements 100c to 100f, respectively.

Referring back to Fig. 9, the command input block 110 comprises an input circuit 111, first to fourth command latch circuits 112 to 115, and first to fourth command decoders 116 to 119. The command input block 110 receives command signals, extracts first to fourth commands from the command signals, and outputs the first to fourth commands as first to fourth internal commands.

The input circuit 111 includes an input amplifier 111a, shapes the command signals, and outputs the shaped command signals. The first to fourth command latch circuits 112 to 115 extract first to fourth commands from the command signals output from the input circuit 111, in synchronization with the internal clock signals #1 to #4, respectively, and output the first to fourth commands, respectively.

The first command decoder 116 decodes the first command supplied from the first command latch circuit 112, generates a first internal command, and supplies the first internal command to a data handling circuit (not shown) in the following stage. In addition, the first internal command is also supplied to the second to fourth command decoders 117 to 119 and a fifth address latch circuit 126 in the address input block 120.

The second to fourth command decoders 117 to 119 respectively receive the outputs of the second to fourth command latch circuits 113 to 115 as well as the output of the first command decoder 116, generate second to fourth internal commands, and output the second to fourth internal commands to the data handling circuit in the following stage. In addition, the second to fourth internal commands are also supplied to sixth to eighth address latch circuits 127 to 129 in the address input block 120, respectively.

The address input block 120 comprises an input circuit 121, first to fourth address latch circuits 122 to 125, and the fifth to eighth address latch circuits 126 to 129. The address input block 120 receives address signals, extracts first to fourth addresses from the address signals, and outputs the first to fourth addresses as first to fourth internal addresses to the data handling circuit in the following stage.

The input circuit 121 includes an input amplifier 121a, shapes the address signals, and outputs the shaped address signals. The first to fourth address latch circuits 122 to 125 extract first to fourth addresses from the shaped address signals, in synchronization with the internal clock signals #1 to #4, respectively, and output the first to fourth addresses, respectively. The fifth to eighth address latch circuits 126 to 129 latch the first to fourth addresses in accordance with the first to fourth internal commands, respectively, and output the first to fourth addresses as first to fourth internal addresses, respectively.

The operations of the data handling device of Fig. 9 are explained below.

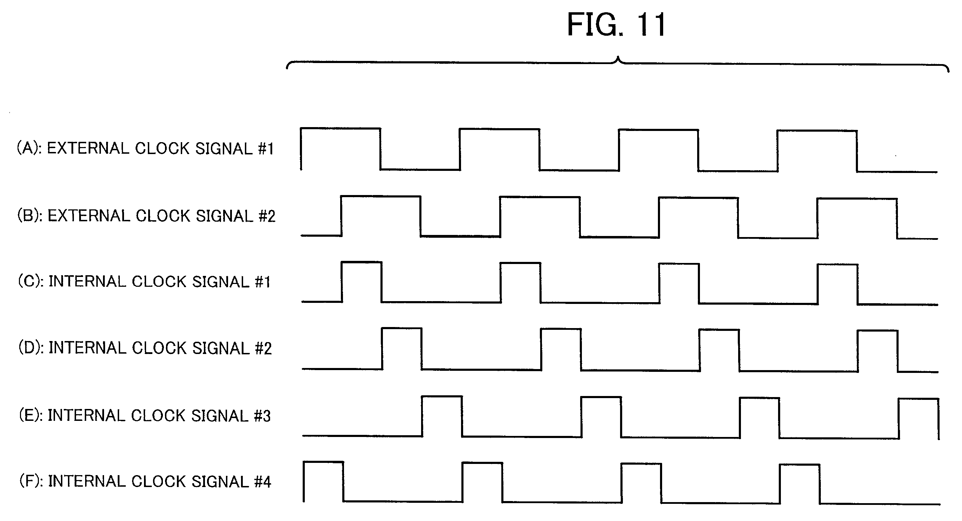

First, the operation of the clock buffer circuit 100 having the construction of Fig. 10 is explained with reference to Fig. 11, which is a timing diagram illustrating operations of the clock buffer circuit 100.

When the external clock signals #1 and #2 (as indicated with (A) and (B) in Fig. 11) having phases which differ by 90 degrees are supplied to the clock buffer circuit 100, the NAND circuit element 100c outputs an inversion of a logical product of the external clock signals #1 and #2, and the inverter 100g outputs as the internal clock signal #1 a further inversion of the output of the NAND circuit element 100c. Since the internal clock signal #1 is substantially identical to the logical product of the external clock signals #1 and #2, the internal clock signal #1 becomes "H" when both of the external clock signals #1 and #2 are "H", as indicated with (C) in Fig. 11.

Similarly, since the internal clock signal #2 is substantially identical to the logical product of the external clock signal #2 and the inversion of the external clock signal #1, the internal clock signal #2 becomes "H" when both of the external clock signal #2 and the inversion of the external clock signal #1 are "H", as indicated with (D) in Fig. 11.

The internal clock signal #3 is substantially identical to the logical product of the inversion of the external clock signal #1 and the inversion of the external clock signal #2. Therefore, the internal clock signal #3 becomes "H" when both of the inversion of the external clock signal #1 and the inversion of the external clock signal #2 are "H", as indicated with (E) in Fig. 11.

The internal clock signal #4 is substantially identical to the logical product of the external clock signal #1 and the inversion of the external clock signal #2, the internal clock signal #2 becomes "H" when both of the external clock signal #1 and the inversion of the external clock signal #2 are "H", as indicated with (F) in Fig. 11.

Thus, the internal clock signals #1 to #4 are generated by the clock buffer circuit 100, where the internal clock signal #1 rises with the rising edge of the internal clock signal #2, the internal clock signal #2 rises with the falling edge of the internal clock signal #1, the internal clock signal #3 rises with the falling edge of the internal clock signal #2, and the internal clock signal #4 rises with the rising edge of the internal clock signal #1.

The internal clock signals #1 to #4 are respectively supplied to the first to fourth command latch circuits 112 to 115 and the first to fourth address latch circuits 122 to 125.

The first to fourth command latch circuits 112 to 115 in the command input block 110 receive the command signals shaped by the input circuit 111, and latch the first to fourth commands in synchronization with rising edges of the internal clock signals #1 to #4, respectively.

The first command decoder 116 decodes the first command supplied from the first command latch circuit 112, generates a first internal command, and supplies the first internal command to the data handling circuit in the following stage, the second to fourth command decoders 117 to 119, and the fifth address latch circuit 126 in the address input block 120.

The second command decoder 117 decodes the first internal command supplied from the first command decoder 116 and the second command supplied from the second command latch circuit 113, and determines whether or not the combination of the first internal command and the second command is normal. When the second command decoder 117 determines that the combination of the first internal command and the second command is normal, the second command decoder 117 generates a second internal command, and outputs the second internal command to the data handling circuit in the following stage and the sixth address latch circuit 127 in the address input block 120.

The second command decoder 117 decodes the first internal command supplied from the first command decoder 116 and the second command supplied from the second command latch circuit 113, and determines whether or not the combination of the first internal command and the second command is normal. When the second command decoder 117 determines that the combination of the first internal command and the second command is normal, the second command decoder 117 generates a second internal command, and outputs the second internal command to the data handling circuit in the following stage and the sixth address latch circuit 127 in the address input block 120.

The third command decoder 118 decodes the first internal command supplied from the first command decoder 116 and the third command supplied from the third command latch circuit 114, and determines whether or not the combination of the first internal command and the third command is normal. When the third command decoder 118 determines that the combination of the first internal command and the third command is normal, the third command decoder 118 generates a third internal command, and outputs the third internal command to the data handling circuit in the following stage and the seventh address latch circuit 128 in the address input block 120.

The fourth command decoder 119 decodes the first internal command supplied from the first command decoder 116 and the fourth command supplied from the fourth command latch circuit 115, and determines whether or not the combination of the first internal command and the fourth command is normal. When the fourth command decoder 119 determines that the combination of the first internal command and the fourth command is normal, the fourth command decoder 119 generates a fourth internal command, and outputs the fourth internal command to the data handling circuit in the following stage and the eighth address latch circuit 129 in the address input block 120.

The first to fourth address latch circuits 122 to 125 in the address input block 120 receive the address signals shaped by the input circuit 121, and latch the first to fourth addresses in synchronization with the internal clock signals #1 to #4, respectively.

The fifth to eighth address latch circuits 126 to 129 respectively latch the first to fourth addresses in accordance with the first to fourth internal commands supplied from the first to fourth command decoders 116 to 119, and output the first to fourth addresses as internal first to fourth addresses to the data handling circuit in the following stage.

Although not shown in Fig. 9, the above data handling circuit performs predetermined processing in accordance with the first and second internal commands supplied from the command input block 110. When the first internal command is supplied from the first command decoder 116 to the data handling circuit, the data handling circuit starts its operation. Subsequently, when the second to fourth internal commands are respectively supplied from the second to fourth command decoders 117 to 119 to the data handling circuit, the data handling circuit appropriately modifies the course of the operation in accordance with the second to fourth internal commands, and continues the operation. When the data handling circuit determines that at least one of the second to fourth commands are not normal (e.g. not executable), it stops the operation.

As explained above, in the data handling device as the third embodiment of the present invention, the internal clock signals #1 to #4 are generated corresponding to the rising edges and the falling edges of the external clock signals, and the data handling device as the third embodiment is arranged so that the commands and addresses are latched in synchronization with the edges of the internal clock signals #1 to #4. Therefore, the command latch circuits are not required to make the aforementioned determinations which are required in the known command input circuit. Thus, the processing speed in the command input block can be increased.

### (5) Fourth Embodiment

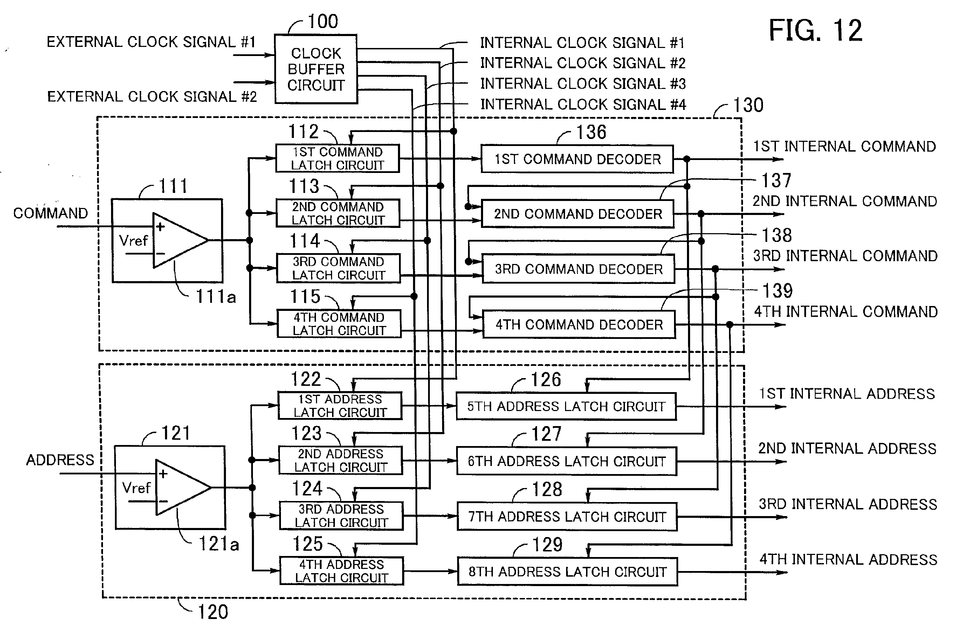

Fig. 12 is a diagram illustrating a construction of a data handling device as a fourth embodiment of the present invention. In Fig. 12, the same elements as Fig. 9 have the same reference numbers as Fig. 9, and the explanations on the same elements as Fig. 9 are not repeated.

As illustrated in Fig. 12, the data handling device as the fourth embodiment of the present invention is different from the data handling device of Fig. 9 in only a portion of the command input block 130.

The command input block 130 comprises an input circuit 111, first to fourth command latch circuits 112 to 115, and first to fourth command decoders 136 to 139. The command input block 130 receives command signals, extracts first to fourth commands from the command signals, and outputs the first to fourth commands as first to fourth internal commands.

The input circuit 111 includes an input amplifier 111a, shapes the command signals, and outputs the shaped command signals. The first to fourth command latch circuits 112 to 115 extract first to fourth commands from the command signals output from the input circuit 111, in synchronization with the internal clock signals #1 to #4, respectively, and output the first to fourth commands, respectively.

The first command decoder 136 decodes the first command supplied from the first command latch circuit 112, generates a first internal command, and supplies the first internal command to the data handling circuit in the following stage. In addition, the first internal command is also supplied to the second command decoder 137 and the fifth address latch circuit 126 in the address input block 120.

The second command decoder 137 decodes the output of the first command decoder 136 and the second command supplied from the second command latch circuit 113, generates a second internal command, and supplies the second internal command to the data handling circuit in the following stage. In addition, the second internal command is also supplied to the third command decoder 138 and the sixth address latch circuit 127 in the address input block 120.

The third command decoder 138 decodes the output of the second command decoder 137 and the third command supplied from the third command latch circuit 114, generates a third internal command, and supplies the third internal command to the data handling circuit in the following stage. In addition, the third internal command is also supplied to the fourth command decoder 139 and the seventh address latch circuit 128 in the address input block 120.

The fourth command decoder 139 decodes the output of the third command decoder 138 and the fourth command supplied from the fourth command latch circuit 115, generates a fourth internal command, and supplies the fourth internal command to the data handling circuit in the following stage. In addition, the fourth internal command is also supplied to the eighth address latch circuit 129 in the address input block 120.

The operations of the data handling device of Fig. 12 are explained below, where the explanations of the same operations of the same elements as the third embodiment of the present invention are not repeated.

The first command decoder 136 decodes the first command supplied from the first command latch circuit 112, generates a first internal command, and supplies the first internal command to the data handling circuit in the following stage, the second command decoder 137, and the fifth address latch circuit 126 in the address input block 120.

The second command decoder 137 decodes the first internal command supplied from the first command decoder 136 and the second command supplied from the second command latch circuit 113, and determines whether or not the combination of the first internal command and the second command is normal. When the second command decoder 137 determines that the combination of the first internal command and the second command is normal, the second command decoder 137 generates a second internal command, and outputs the second internal command to the data handling circuit in the following stage, the third command decoder 138, and the sixth address latch circuit 127 in the address input block 120.

The second command decoder 137 decodes the first internal command supplied from the first command decoder 136 and the second command supplied from the second command latch circuit 113, and determines whether or not the combination of the first internal command and the second command is normal. When the second command decoder 137 determines that the combination of the first internal command and the second command is normal, the second command decoder 137 generates a second internal command, and outputs the second internal command to the data handling circuit in the following stage, the third command decoder 138, and the sixth address latch circuit 127 in the address input block 120.

The third command decoder 138 decodes the second internal command supplied from the second command decoder 137 and the third command supplied from the third command latch circuit 114, and determines whether or not the combination of the second internal command and the third command is normal. When the third command decoder 138 determines that the combination of the second internal command and the third command is normal, the third command decoder 138 generates a third internal command, and outputs the third internal command to the data handling circuit in the following stage, the fourth command decoder 139, and the seventh address latch circuit 128 in the address input block 120.

The fourth command decoder 139 decodes the third internal command supplied from the third command decoder 138 and the fourth command supplied from the fourth command latch circuit 115, and determines whether or not the combination of the third internal command and the fourth command is normal. When the fourth command decoder 139 determines that the combination of the third internal command and the fourth command is normal, the fourth command decoder 139 generates a fourth internal command, and outputs the fourth internal command to the data handling circuit in the following stage and the eighth address latch circuit 129 in the address input block 120.

When the first internal command is supplied from the first command decoder 136 to the data handling circuit arranged in the stage following the command input block 130, the data handling circuit starts its operation. Subsequently, when the second to fourth internal commands are respectively supplied from the second to fourth command decoders 137 to 139 to the data handling circuit, the data handling circuit appropriately modifies the course of the operation in accordance with the second to fourth internal commands, and continues the operation. When the data handling circuit determines that at least one of the second to fourth commands are not normal, the data handling circuit stops the operation.

When the first internal command is supplied from the first command decoder 136 to the data handling circuit arranged in the stage following the command input block 130, the data handling circuit starts its operation. Subsequently, when the second to fourth internal commands are respectively supplied from the second to fourth command decoders 137 to 139 to the data handling circuit, the data handling circuit appropriately modifies the course of the operation in accordance with the second to fourth internal commands, and continues the operation. When the data handling circuit determines that at least one of the second to fourth commands are not normal, the data handling circuit stops the operation.

As explained above, in the data handling device as the fourth embodiment of the present invention, for the same reason as the third embodiment, the command latch circuits are not required to make the aforementioned determinations which are required in the known command input circuit. Thus, the processing speed in the command input block can be increased.

### (6) Variations and Other Matters

(i) Although the commands and the addresses are
latched in synchronization with the rising edges and the falling edges of the two external clock signals #1 and #2 in the third and fourth embodiments of the present invention, it is possible to arrange the data handling devices so that commands and addresses are latched in synchronization with rising edges and falling edges of more than two external clock signals. Further, it is possible to arrange the data handling devices so that commands and addresses are latched in synchronization with only a portion of rising edges and falling edges of more than one external clock signal.
(ii) The foregoing is considered as illustrative only of the principle of the present invention. Further, since numerous modifications and changes will readily occur to those skilled in the art, it is not desired to limit the invention to the exact construction and applications shown and described, and accordingly, all suitable modifications and equivalents may be regarded as falling within the scope of the invention in the appended claims and their equivalents.

## Claims

1. A command input circuit comprising:
a clock signal supplying unit (50) which supplies a clock signal to a first command acquisition unit (62) and a second command acquisition unit (63);
a command input unit (60,80) which receives a first command and a second command, and supplies the first command and the second command to a first command acquisition unit (62) and a second command acquisition unit (63);
wherein said first command acquisition unit (62) acquires said first command in response to a first edge of said clock signal, where the first edge is one of a rising edge and a falling edge of the clock signal; and
said second command acquisition unit (63) acquires said second command in response to a second edge of said clock signal, where the second edge is an edge of the clock signal which is different from said first edge.

2. A data handling device comprising:
a command input circuit according to claim 1; and
a processing unit (14) which performs processing in accordance with said first command and said second command.

3. The data handling device according to claim 2,
wherein said processing unit starts said processing when the processing unit receives said first command.

4. The data handling device according to claim 2 or 3, wherein said processing unit stops said processing when said processing unit determines that said second command is not normal.

5. The data handling device according to any of claims 2 to 4, wherein said processing unit goes into a predetermined operation mode corresponding to said second command when the processing unit receives the second command.

6. The data handling device according to any of claims 2 to 5, further comprising,
an address input unit (70) which receives a first address and a second address, and supplies the first address and the second address to a first address acquisition unit (72) and a second address acquisition unit (73),
wherein said first address acquisition unit acquires said first address in response to said first edge of said clock signal, and
said second address acquisition unit acquires said second address in response to said second edge of said clock signal.

7. The data handling device according to any of claims 2 to 6, further comprising a data input-and-output unit which receives and outputs data in response to said rising edge and said falling edge of the clock signal.

8. A command input circuit comprising:
m command acquisition units (112 to 115) which are provided corresponding to first to mth commands, respectively, where m is an integer greater than one;
a clock signal supplying unit (100) which supplies n clock signals respectively having different phases to said m command acquisition units, where n is an integer greater than one; and
a command input unit (110, 130) which receives said first to mth commands, and supplies the first to mth commands to said m command acquisition units;
wherein each of the m command acquisition units acquires one of said first to mth commands corresponding to said each of the m command acquisition units in response to one of m edges of said n clock signals corresponding to said one of the first to mth commands.

9. A data handling device comprising:
a command input circuit according to claim 8; and
a processing unit which performs processing in accordance with said first to mth commands.

10. The data handling device according to claim 9, wherein said processing unit starts said processing when the processing unit receives said first command.

11. The data handling device according to claim 9 or 10, wherein said processing unit stops said processing when said processing unit determines that one of said second to mth commands is not normal.

12. The data handling device according to any of claims 9 to 11, wherein said processing unit goes into a predetermined operation mode corresponding to one of said second to mth commands when the processing unit receives said one of said second to mth commands.

13. The data handling device according to any of claims 9 to 12, wherein said first command indicates one of no operation, a read operation, and a write operation,
said processing unit starts said processing when the processing unit receives said first command, and
when the processing unit receives at least a portion of said second to mth commands, said processing unit determines whether to continue one of said read operation and said write operation or to go into a predetermined operation mode, according to a combination of the first command and said at least a portion of said second to mth commands.

14. The data handling device according to any of claims 9 to 13, further comprising,
first to pth address acquisition units (122 to 125) which are provided corresponding to first to pth addresses, respectively, where p is an integer greater than one, and
an address input unit (120) which receives said first to pth addresses, and supplies the first to pth addresses to said first to pth address acquisition units,
wherein each of said first to pth address acquisition units acquires one of said first to pth addresses corresponding to said each of said first to pth address acquisition units in response to one of first to pth edges of said n clock signals corresponding to said one of the first to pth addresses.

15. The data handling device according to any of claims 9 to 14, further comprising a data input-and-output unit which receives or outputs data in response to j edges of the n clock signals, where j is an integer greater than one.
